# FASCICULE DE BREVET EUROPEEN

(11) **EP 4 507 468 B1**
(45) Date de publication et mention de la délivrance du brevet: **19.11.2025**
(21) Numéro de dépôt: 24185026.2
(22) Date de dépôt: 27.06.2024
(51) Int. Cl.: H05K 7/20

(54) **DISPOSITIF DE REFROIDISSEMENT D'UN ÉQUIPEMENT ÉLECTRIQUE, SYSTÈME CORRESPONDANT ET AÉRONEF COMPORTANT AU MOINS UN TEL SYSTÈME**
KÜHLVORRICHTUNG FÜR EINE ELEKTRISCHE ANLAGE, ENTSPRECHENDES SYSTEM UND FLUGZEUG MIT MINDESTENS EINEM SOLCHEN SYSTEM
DEVICE FOR COOLING ELECTRICAL EQUIPMENT, CORRESPONDING SYSTEM AND AIRCRAFT COMPRISING AT LEAST ONE SUCH SYSTEM

(30) Priorité: 09.08.2023 FR 2308616
(43) Date de publication de la demande: 12.02.2025
(73) Titulaire: Airbus (S.A.S.), 31700 Blagnac (FR)
(72) Inventeur: LOEHRMANN, Antoine, TOULOUSE (FR)
(74) Mandataire: Airbus-OPS SAS

(56) Documents cités:
- FR-A1- 3 108 823
- FR-A1- 3 129 266

## Description

### DOMAINE TECHNIQUE

La présente invention concerne un dispositif de refroidissement pour les équipements électriques et/ou électroniques (regroupés sous les termes « équipements électriques » dans la suite de la description). L'invention concerne plus particulièrement le refroidissement de tels équipements par la circulation d'un fluide de refroidissement diphasique. L'invention concerne également un système de refroidissement comportant un dispositif de refroidissement et un équipement électrique, ainsi qu'un aéronef comportant au moins un tel système.

### ÉTAT DE LA TECHNIQUE ANTÉRIEURE

Dans le cadre de l'électrification des aéronefs, on a vu les besoins en énergie augmenter significativement en quelques années. En effet, les systèmes électriques liés au vol de l'aéronef (commandes de vol, calculateurs, ordinateurs de vol, etc) et les systèmes électriques dédiés aux passagers (systèmes de pressurisation, systèmes de ventilation, systèmes numériques de divertissement, etc) engendrent une augmentation de la puissance à délivrer pour assurer un fonctionnement optimal de l'aéronef dans toutes les conditions.

Toutefois, pour répondre à ces besoins croissants de puissance, il n'est pas toujours possible d'augmenter la taille des équipements électriques puisque des contraintes d'encombrement et de poids, notamment, doivent être respectées.

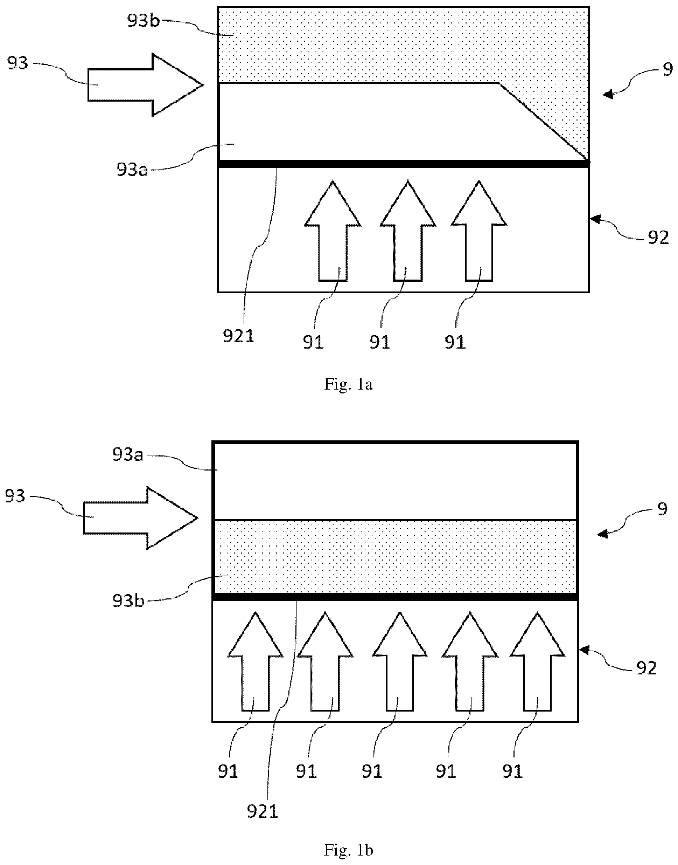

Pour tenter de respecter la contrainte relative à l'encombrement de ces équipements électriques, une solution consiste à augmenter la température de fonctionnement de l'électronique de puissance de ces équipements, ce qui engendre toutefois des pertes thermiques très importantes. Pour y remédier, le système de refroidissement liquide classique monophasique a été remplacé par un système de refroidissement diphasique 9 illustré sur les Figs. 1a et 1b, également appelé système de refroidissement à changement de phase. Ainsi, le fluide de refroidissement 93 circulant autour ou sur l'équipement électrique 92 va changer de phase, c'est-à-dire que le fluide de refroidissement 93 va passer de l'état liquide 93a à l'état gazeux 93b au contact de la paroi 921 du circuit de l'équipement électrique 92.

Un inconvénient de cette solution réside dans le fait qu'en cas de flux thermique 91 trop important engendré par l'équipement électrique 92, en d'autres termes en cas de flux thermique excessif (appelé flux thermique critique - CHF), la paroi 921 risque de s'assécher, comme illustré sur la Fig. 1b. Si la paroi 921 est asséchée, c'est-à-dire si la paroi 921 n'est plus en contact avec le fluide 93a à l'état liquide, la température du circuit de l'équipement électrique 92 ne va faire qu'augmenter de manière exponentielle. Les risques de dégradation, voire de destruction, de l'équipement électrique 92 sont donc très élevés.

Pour contrer cette situation, il est connu de réduire la puissance de l'équipement électrique, au moins provisoirement, pour faire redescendre la température du circuit. Or, cette réduction de puissance peut s'avérer impossible, voire dangereuse, par exemple lors de la phase de décollage de l'aéronef ou lors de manœuvres spécifiques.

Le document FR3108823 décrit un circuit de refroidissement d'un module de puissance qui présente des excroissances supplémentaires pour augmenter la surface des échanges thermiques avec le liquide de refroidissement.

Le document FR3129266 décrit un circuit de refroidissement d'un module de puissance dont le fluide de refroidissement est un fluide bi-phasique.

Il existe donc un besoin de fournir une solution de refroidissement d'un équipement électrique, notamment pour aéronef, qui remédie au moins en partie aux inconvénients précités. De préférence, cette solution doit être efficace, simple à mettre en œuvre et peu encombrante.

### EXPOSÉ DE L'INVENTION

Un objet de la présente invention est de proposer un dispositif de refroidissement d'un équipement électrique qui soit simple à mettre en œuvre et qui respecte les contraintes d'encombrement liées aux aéronefs notamment.

À cet effet, est proposé un dispositif de refroidissement d'un équipement électrique, ledit équipement électrique comportant un circuit dont la température est croissante entre un fonctionnement nominal dudit équipement électrique dans lequel le circuit délivre une puissance nominale et un fonctionnement critique dans lequel le circuit délivre une puissance critique supérieure à la puissance nominale, ledit dispositif (1) comportant :
- un canal de circulation contenant un flux d'un fluide de refroidissement, ledit fluide de refroidissement étant un fluide diphasique comportant une phase liquide et une phase gazeuse,
- une paroi thermiquement conductrice destinée à séparer ledit canal et ledit circuit et destinée à être en contact avec ledit circuit,
- au moins une ailette disposée au sein dudit canal et s'étendant à partir de ladite paroi, chaque ailette comportant une extrémité proximale solidaire de ladite paroi et une extrémité distale à l'opposé de l'extrémité proximale, chaque ailette étant mobile entre une position rapprochée, dans laquelle l'extrémité distale est rapprochée de ladite paroi, et une position éloignée, dans laquelle l'extrémité distale est éloignée de ladite paroi et fait au moins en partie obstacle audit flux de fluide de refroidissement.

Ladite au moins une ailette est configurée pour être en position rapprochée lorsqu'une température de l'ailette est inférieure à une température prédéterminée, et être en position éloignée lorsque ladite température de l'ailette est supérieure ou égale à ladite température prédéterminée.

Selon l'invention, la température prédéterminée est égale à la température de changement de phase dudit fluide de refroidissement.

Le dispositif de refroidissement de l'invention permet donc de refroidir efficacement un équipement électrique sans avoir à diminuer la puissance de ce dernier lors de pertes thermiques très élevées.

Selon un aspect particulier de l'invention, ladite au moins une ailette comporte une première surface faisant face à ladite paroi lorsque ladite au moins une ailette est en position rapprochée, et une deuxième surface opposée à ladite première surface. Dans la position éloignée, ladite au moins une ailette est inclinée par rapport à ladite paroi et ledit flux de fluide de refroidissement circule en direction de ladite deuxième surface de ladite au moins une ailette.

Selon un aspect particulier de l'invention, ladite au moins une ailette comporte une première partie en métal et une deuxième partie en alliage à mémoire de forme.

Selon un autre aspect particulier de l'invention, ladite deuxième partie comporte une première portion solidaire de ladite paroi et une deuxième portion solidaire de ladite première portion au niveau d'une jonction élastiquement déformable, ladite deuxième portion étant mobile par rapport à ladite paroi entre la position rapprochée et la position éloignée.

Selon encore un autre aspect particulier de l'invention, ladite première partie recouvre au moins en partie ladite deuxième portion.

Selon un aspect particulier de l'invention, ladite première partie en métal est sélectionnée parmi : le cuivre, l'aluminium, l'or, ou l'inconel^{®}, et ladite deuxième partie 157 en alliage à mémoire de forme est sélectionnée parmi : le Nitinol (alliage Nickel-Titane), l'alliage Cuivre-Zinc-Aluminium, l'alliage Cuivre-Aluminium-Nickel ou l'alliage Fer-Manganèse-Silicium.

Selon un aspect particulier de l'invention, ladite deuxième portion de l'ailette présente une longueur configurée pour que, lorsque ladite au moins une ailette est en position éloignée, au moins l'extrémité distale de ladite ailette atteigne la phase liquide lorsque ladite paroi est séparée de ladite phase liquide par la phase gazeuse dudit fluide de refroidissement.

Selon un aspect particulier de l'invention, le dispositif comporte une pluralité d'ailettes, lesdites ailettes étant disposées sur ladite paroi en ligne, en quinconce, ou une combinaison de ces dispositions.

L'invention concerne également un système de refroidissement comportant un équipement électrique et un dispositif tel que décrit précédemment, dans lequel la paroi du dispositif est en contact avec le circuit de l'équipement électrique.

L'invention concerne en outre un aéronef comportant au moins un système de refroidissement tel que décrit précédemment.

### BRÈVE DESCRIPTION DES DESSINS

Les caractéristiques de l'invention mentionnées ci-dessus, ainsi que d'autres, apparaîtront plus clairement à la lecture de la description suivante d'un exemple de réalisation, ladite description étant faite en relation avec les dessins joints, parmi lesquels :
Fig. 1a illustre schématiquement un système de refroidissement diphasique selon l'art antérieur, lorsqu'un équipement électrique à refroidir est en fonctionnement nominal ;
Fig. 1b illustre schématiquement le système de la Fig. 1a, lorsque l'équipement électrique à refroidir fonctionne à pleine puissance ;
Fig. 2 illustre schématiquement un système de refroidissement selon l'invention, lorsqu'un équipement électrique à refroidir est en fonctionnement nominal ;
Fig. 3 illustre schématiquement le système de la Fig. 2, lorsque l'équipement électrique à refroidir fonctionne à pleine puissance ;
Fig. 4 illustre schématiquement et de manière isolée un dispositif de refroidissement selon l'invention, lorsque l'équipement électrique à refroidir fonctionne à pleine puissance ; et
Fig. 5 illustre un aéronef comportant une pluralité de systèmes de refroidissement selon l'invention.

### EXPOSÉ DÉTAILLÉ D'UNE MODE DE RÉALISATION

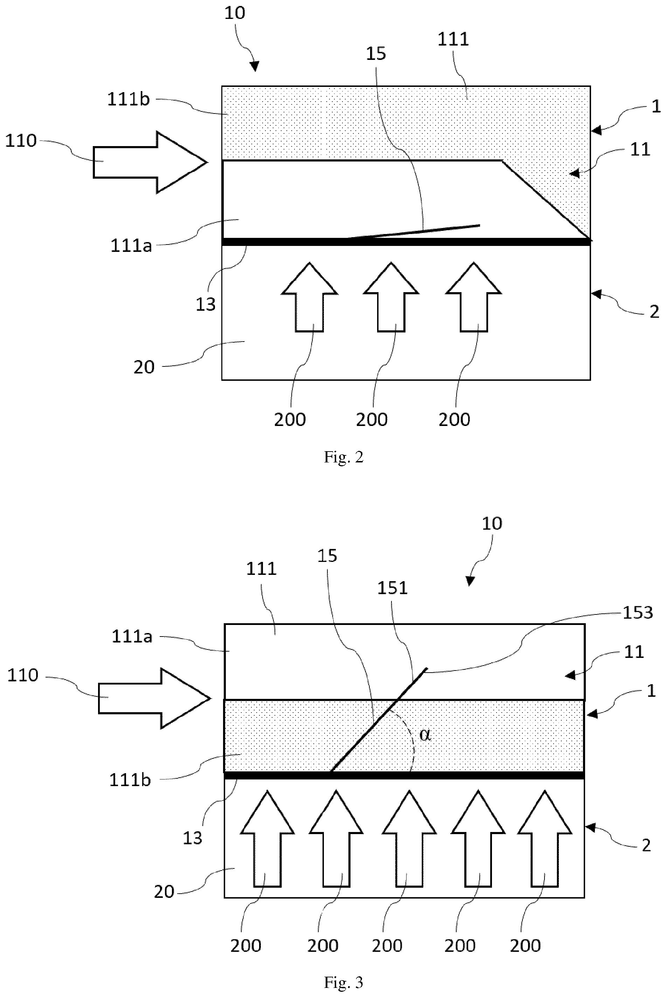

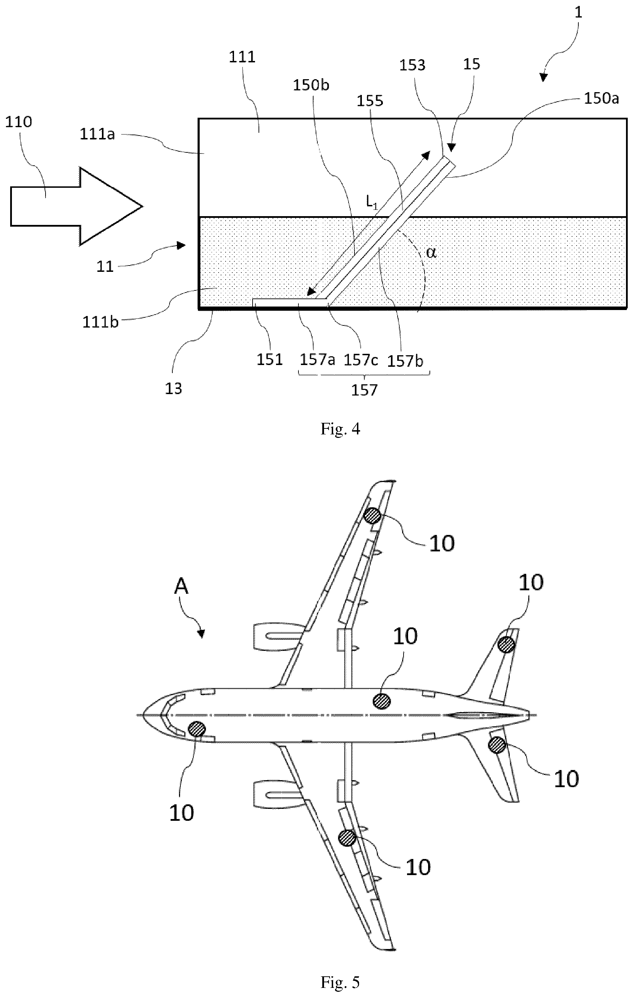

Les Figs. 2 à 4 illustrent schématiquement un dispositif 1 de refroidissement selon l'invention. Ce dispositif 1 est destiné à refroidir un équipement électrique 2, et de préférence un équipement électrique 2 destiné à être embarqué dans un aéronef A illustré sur la Fig. 5.

L'équipement électrique 2 comporte un circuit 20, par exemple un circuit d'électronique de puissance, engendrant un flux thermique 200 lors de son fonctionnement. Du fait de ce flux thermique 200, la température T1 du circuit 20 est variable en fonction du fonctionnement du circuit 20. Ainsi, la température T1 du circuit 20 augmente lorsque la puissance délivrée par le circuit 20 augmente. Plus précisément, la température T1 du circuit 20 est croissante entre un fonctionnement nominal de l'équipement électrique 2 dans lequel le circuit 20 délivre une puissance nominale P1 et un fonctionnement critique dans lequel le circuit 20 délivre une puissance critique P2 supérieure à la puissance nominale P1.

Par exemple, la puissance nominale P1 englobe une plage de valeurs de puissances correspondant au fonctionnement nominal de l'équipement électrique 2. La puissance critique P2 peut être une valeur de puissance à partir de laquelle l'équipement électrique 2 est considéré comme fonctionnant à pleine puissance.

Lorsque la puissance critique P2 est atteinte, la température T1 du circuit 20 atteint une valeur critique. À partir de cette température critique, le flux thermique 200 est appelé flux de chaleur critique (pour critical heat flux - CHF - en anglais).

Le dispositif 1 de refroidissement de l'invention destiné à refroidir un tel équipement électrique 2 comporte un canal 11 de circulation contenant un flux 110 de fluide de refroidissement 111. Selon l'invention, le fluide de refroidissement 111 circulant dans le canal 11 est un fluide diphasique, c'est-à-dire que le fluide de refroidissement 111 comprend deux phases, à savoir une phase liquide 111a et une phase gazeuse 111b, dans la plage de température de fonctionnement du circuit 20.

Le dispositif 1 comporte également une paroi 13 disposée entre le canal 11 et le circuit 20 de l'équipement électrique 2 et séparant le canal 11 du circuit 20. La paroi 13 est thermiquement conductrice et est en contact avec le circuit 20 de sorte à favoriser les échanges thermiques du circuit 20 vers le flux 110, ce qui permet de refroidir le circuit 20. Dans une variante, il est envisageable que la paroi 13 soit constituée par une paroi de l'équipement électrique 2.

Par exemple, la paroi 13 est fabriquée en cuivre, ou en aluminium, ou en or, ou en inconel^{®} (super alliage constitué principalement de nickel, de chrome, de fer, de magnésium et de titane), ou en tout autre métal suffisamment conducteur thermiquement, par exemple un métal avec une conductivité thermique supérieure à 30 W/mK.

Selon l'invention, le dispositif 1 comporte au moins une ailette 15 élastique disposée au sein du canal 11. Dans l'exemple illustré schématiquement sur les Figs. 2 à 4, une seule ailette 15 est représentée et la suite de cette description se base sur cet exemple. On comprend aisément que le dispositif 1 pourrait mettre en œuvre une pluralité d'ailettes 15 et que la description qui va suivre de l'ailette 15 pourrait s'appliquer à l'ensemble des ailettes 15 lorsque le dispositif 1 comporte une pluralité d'ailettes 15.

L'ailette 15 s'étend à partir de la paroi 13. Plus précisément, l'ailette 15 comporte une extrémité proximale 151 solidaire de la paroi 13 et une extrémité distale 153 à l'opposé de l'extrémité proximale 151. L'ailette 15 est mobile entre une position rapprochée, dans laquelle l'extrémité distale 153 est rapprochée de la paroi 13 (en d'autres termes, l'ailette 15 est abaissée et s'étend globalement parallèlement à la paroi 13), et une position éloignée, dans laquelle l'extrémité distale 153 est éloignée de la paroi 13 (en d'autres termes, l'ailette 15 est inclinée par rapport à la paroi 13). Lorsque l'ailette 15 est en position éloignée, l'ailette 15 fait au moins en partie obstacle au flux 110 de fluide de refroidissement 111 de sorte à créer des perturbations dans le flux 110 et augmenter les échanges thermiques entre le circuit 20 et le fluide de refroidissement 111.

Plus précisément, l'ailette 15 est configurée pour être en position rapprochée lorsque la température T3 de l'ailette 15 est inférieure à une température prédéterminée Tref et être en position relevée lorsque la température T3 de l'ailette 15 est supérieure ou égale à la température prédéterminée Tref.

La position rapprochée de l'ailette 15 correspond à un état dans lequel l'équipement électrique 2 est en fonctionnement nominal. Ainsi, la puissance P1 délivrée par le circuit 20 de l'équipement électrique 2 est alors considérée comme nominale. La température T1 du circuit 20 est donc également comprise dans les valeurs normales de fonctionnement. Les échanges thermiques entre le circuit 20 et le fluide de refroidissement 111 du flux 110 sont donc suffisants pour refroidir la paroi 13. Dans cette situation, la phase liquide 111a du fluide de refroidissement 111 recouvre donc en totalité la paroi 13. En d'autres termes, la phase gazeuse 111b n'est pas en contact avec la paroi 13 et la paroi 13 est donc totalement humide. Le refroidissement de l'équipement électrique 2 est donc efficace.

Lorsque le circuit 20 délivre une puissance plus élevée qui atteint ou dépasse la puissance critique P2, la température T1 du circuit 20 augmente. L'augmentation de la température T1 du circuit 20 va, par conséquent, faire augmenter la température T2 du fluide de refroidissement 111 et donc la température T3 de l'ailette 15 jusqu'à ce que la température T3 de l'ailette 15 atteigne et éventuellement dépasse la température prédéterminée Tref.

Selon un mode de réalisation, la température prédéterminée Tref correspond sensiblement à la température de changement de phase du fluide de refroidissement 111. Ainsi, lorsque la température prédéterminée Tref est atteinte, le fluide de refroidissement 111 va changer de phase de sorte que le volume de la phase liquide 111a va diminuer et que le volume de la phase gazeuse 11b va augmenter. De plus, du fait de la capillarité du fluide de refroidissement 111, la phase gazeuse 111b va prendre la place de la phase liquide 111a et va venir au moins en partie recouvrir la paroi 13. La paroi 13 va donc s'assécher aux endroits où la phase liquide 111a ne recouvre plus la paroi 13 et la température T1 du circuit 20 va augmenter de manière exponentielle. Dans cette situation, la paroi 13 est donc au moins en partie séparée de la phase liquide 111a par la phase gazeuse 111b.

Dans l'état de la technique, cette situation est habituellement critique et nécessite de diminuer la puissance du circuit 20 pour permettre à la température T1 du circuit 20 de baisser et, par voie de conséquence, à la température T2 du fluide de refroidissement 111 de baisser également pour que la paroi 13 soit de nouveau recouverte par la phase liquide 111a. Or, cette nécessité de baisser la puissance délivrée par le circuit 20 n'est pas satisfaisante.

Selon l'invention, l'ailette 15 est configurée pour être en position éloignée lorsque la température T3 de l'ailette 15 atteint ou dépasse la température prédéterminée Tref, c'est-à-dire lorsque la température T3 de l'ailette 15 est supérieure ou égale à la température prédéterminée Tref. Étant donné que la température prédéterminée Tref est égale à la température de changement de phase du fluide de refroidissement 111, l'ailette 15 passe de la position rapprochée à la position éloignée globalement lors du changement de phase du fluide de refroidissement 111. En effet, la température T3 de l'ailette 15 est globalement identique à la température T2 du fluide de refroidissement 111 puisque l'ailette 15 baigne dans le fluide de refroidissement 111 (c'est-à-dire que l'ailette 15 est en contact direct avec le fluide de refroidissement 111). Un écart relativement faible, compris entre cinq et dix degrés (en fonction du fluide de refroidissement utilisé et des aspérités de l'ailette 15), entre la température T2 du fluide de refroidissement 111 et la température T3 de l'ailette 15 peut toutefois être observé lors de changements brusques de la température T1 du circuit 20. Lorsqu'il n'y a pas ou peu de variations de la température T1 du circuit 20, la température T3 de l'ailette 15 tend à être égale à la température T2 du fluide de refroidissement 111.

Dans la position éloignée de l'ailette 15, on considère que l'équipement électrique 2 est dans son fonctionnement critique, comme décrit ci-dessus. Ainsi, la température T2 du fluide de refroidissement 111 est donc égale ou supérieure à la température prédéterminée Tref. Par conséquent, la phase liquide 111a du fluide de refroidissement 111 n'est au moins en partie plus en contact avec la paroi 13, qui de ce fait s'assèche. En fonction de la température T2 du fluide de refroidissement 111, et donc du changement de phase du liquide de refroidissement 111, il se peut que la paroi 13 soit totalement asséchée (c'est-à-dire totalement recouverte par la phase gazeuse 111b) ou partiellement asséchée (c'est-à-dire qu'une partie de la paroi 13 est recouverte de la phase liquide 111a et qu'une autre partie est recouverte du la phase gazeuse 111b).

Le déplacement de l'ailette 15 de la position rapprochée à la position éloignée de la paroi 13 permet de créer des perturbations dans le flux 110 de fluide de refroidissement 111 qui permettent d'augmenter les échanges thermiques et donc d'assurer le transfert thermique entre la paroi 13 et le fluide de refroidissement 111. Ainsi, le circuit 20 peut continuer de fonctionner à pleine puissance, sans échauffement pouvant créer un obstacle au bon fonctionnement de l'équipement électrique 2.

Dans le mode de réalisation illustré, l'ailette 15 comporte une première surface 150a qui fait face à la paroi 13 lorsque l'ailette 15 est en position rapprochée. L'ailette 15 présente une deuxième surface 150b qui est opposée à la première surface 150a, et qui est située du côté du canal 11 lorsque l'ailette 15 est en position rapprochée. Dans la position éloignée, c'est-à-dire lorsque l'ailette 15 est inclinée par rapport à la paroi 13, ou en d'autres termes lorsque l'ailette 15 est redressée, le flux 110 de fluide de refroidissement 111 circule en direction de la deuxième surface 150b de l'ailette 15. De cette manière, l'ailette 15 peut créer des perturbations dans le flux 110 lorsque la température T3 de l'ailette 15 est supérieure ou égale à la température prédéterminée Tref. Lorsque la température T3 de l'ailette 15 baisse et repasse sous la température prédéterminée Tref, alors l'ailette 15 doit retourner en position rapprochée. Avec cette disposition et cette inclinaison de l'ailette 15, le flux 110 ne s'oppose pas au déplacement de l'ailette 15 vers la position rapprochée. Au contraire, la direction du flux 110 (représentée par la flèche 110 sur les Figs. 2 et 3) est favorable au déplacement de l'ailette 15 de la position éloignée à la position rapprochée.

Selon un aspect particulier illustré sur la Fig. 4, l'ailette 15 est bimétallique et est constituée au moins d'un matériau à mémoire de forme. Plus précisément, l'ailette 15 comporte une première partie 155 en métal et une deuxième partie 157 en alliage à mémoire de forme. La deuxième partie 157 en alliage à mémoire de forme permet une déformation élastique de l'ailette 15. La déformation de l'ailette 15 est provoquée par le changement de la température T3 de l'ailette 15.

Plus précisément, la deuxième partie 157 est configurée pour déformer l'ailette 15 et faire passer l'ailette 15 de la position rapprochée à la position éloignée lorsque la température T3 de l'ailette 15, qui est sensiblement égale à la température T2 du fluide de refroidissement 111, atteint ou dépasse la température prédéterminée Tref. Tant que la température T3 de l'ailette 15 est supérieure ou égale à la température prédéterminée Tref, l'alliage à mémoire de forme de la deuxième partie 157 va maintenir l'ailette 15 en position éloignée. C'est donc l'alliage à mémoire de forme de la deuxième partie 157 qui réagit au changement de température. Ainsi, lorsque la température T3 de l'ailette 15 va diminuer et repasser sous la température prédéterminée Tref, la deuxième partie 157 va se déformer de nouveau pour retrouver sa forme initiale tandis que la première partie 155 métallique va assister le retour en position rapprochée de l'ailette 15, étant donné que la première partie 155 métallique est opérée dans son domaine élastique.

La deuxième partie 157 en alliage à mémoire de forme passe par une phase dite « d'apprentissage » pendant laquelle l'ailette apprend à passer de la position rapprochée à la position éloignée, et inversement, à une température désirée. La première partie 155 en métal permet d'assister le déplacement de la position éloignée à la position rapprochée. Une telle ailette 15 élastiquement déformable en fonction de la température T3 de cette dernière permet de s'affranchir de l'utilisation d'un mécanisme ou d'un actionneur pour déplacer l'ailette 15 entre la position rapprochée et la position éloignée, et inversement. Le dispositif 1 présente donc un encombrement réduit qui se trouve être optimisé et particulièrement adapté pour être mis en œuvre dans un aéronef, par exemple.

De préférence, la deuxième partie 157 en alliage à mémoire de forme comporte une première portion 157a solidaire de la paroi 13 et une deuxième portion 157b mobile par rapport à la paroi 13. La première portion 157a, qui constitue une base, est de préférence fixée à la paroi 13 d'une façon assurant une bonne conduction thermique. Par exemple, la fixation de la première portion 157a à la paroi 13 est obtenue par brasage, soudure à froid, soudure laser ou toute autre technique permettant d'obtenir les mêmes avantages. Le type de fixation est notamment sélectionné en fonction du matériau de la paroi 13 et de l'alliage à mémoire de forme constituant la deuxième partie 157 de l'ailette 15, du fluide de refroidissement 111 utilisé et de la température T1 de fonctionnement du circuit 20.

La deuxième partie 157 comporte également une jonction 157c entre la première 157a et la deuxième 157b portions. Cette jonction 157c constitue le point de déformation élastique de l'ailette 15 et permet à l'ailette 15 de se déplacer entre la position rapprochée et la position éloignée.

De préférence, la première partie 155 métallique recouvre au moins en partie la deuxième portion 157b de la deuxième partie 157 de l'ailette 15. De préférence, la première partie 155 recouvre une surface de la deuxième portion 157b de la deuxième partie 157 de l'ailette 15, et de préférence encore, la deuxième partie 155 recouvre la deuxième surface 150b de l'ailette 15. Comme précédemment, et en fonction du matériau de la paroi 13 et de l'alliage à mémoire de forme constituant la deuxième partie 157 de l'ailette 15, du fluide de refroidissement 111 utilisé et de la température T1 de fonctionnement du circuit 20 notamment, la première partie 155 est fixée à la deuxième portion 157b de la deuxième partie 157 par collage, soudage à froid, soudage laser ou tout autre technique permettant d'obtenir les mêmes avantages. De préférence, la fixation de la première partie 155 à la deuxième portion 157b est effectuée à chacune des extrémités de la deuxième portion 157b, c'est-à-dire à proximité de la jonction 157c et au niveau de l'extrémité distale 153. De préférence, la première partie 155 en métal est sélectionnée parmi : le cuivre, ou l'aluminium, ou l'or, ou l'inconel^{®}, ou tout autre métal suffisamment conducteur thermiquement, par exemple un métal avec une conductivité thermique supérieure à 30 W/mK.

La deuxième partie 157 en alliage à mémoire de forme est sélectionnée parmi : le Nitinol (alliage Nickel-Titane), ou l'alliage Cuivre-Zinc-Aluminium, ou l'alliage Cuivre-Aluminium-Nickel, ou l'alliage Fer-Manganèse-Silicium.

De préférence, la deuxième portion 157b de l'ailette 15 présente une longueur L₁ (illustrée sur la Fig. 4) configurée pour que, lorsque l'ailette 15 est en position éloignée, au moins l'extrémité distale 153 de l'ailette 15 atteigne la phase liquide 111b du fluide de refroidissement lorsque la paroi 13 est séparée de la phase liquide 111a par la phase gazeuse 111b. En d'autres termes, lors du fonctionnement critique de l'équipement électrique 2 et donc lorsque la paroi 13 est asséchée ou partiellement asséchée (c'est-à-dire recouverte totalement ou partiellement par la phase gazeuse 111b), la longueur L₁ de la deuxième portion 157b de l'ailette 15 est suffisante pour atteindre la phase liquide 111a. De cette manière, l'ailette 15 va créer des perturbations dans le flux 110 de fluide de refroidissement 111 qui va favoriser les échanges thermiques. Plus particulièrement, le fait que l'ailette 15 puisse atteindre la phase liquide 111a lorsque la paroi 13 est séparée de la phase liquide 111a par la phase gazeuse 111b permet également de créer des perturbations dans la phase liquide 111a du flux 110 pour encore améliorer les échanges thermiques. Ainsi, la température T2 du fluide de refroidissement 111 diminue plus rapidement. Il en est donc de même pour la température T1 du circuit 20.

Selon un mode de réalisation, la deuxième portion 157b de l'ailette 15 présente une longueur inférieure à la longueur nécessaire pour que, lorsque l'ailette 15 est en position éloignée, au moins l'extrémité distale 153 de l'ailette 15 atteigne la phase liquide 111b du fluide de refroidissement lorsque la paroi 13 est séparée de la phase liquide 111a par la phase gazeuse 111b. Autrement dit, la deuxième portion 157b de l'ailette 15 n'atteint pas la phase liquide 111b lorsque la paroi 13 est asséchée. Le déploiement de l'ailette 15 force la recirculation du fluide, ce qui augmente les échanges thermiques, réduisant la température de l'ailette 15 et de la paroi 13, et donc un remouillage de la paroi 13 est possible. Selon cette configuration, l'efficacité du refroidissement est amoindrie et le temps de remouillage est allongé par rapport à la configuration où la deuxième portion 157b de l'ailette 15 a une longueur suffisante pour atteindre la phase liquide 111b.

Préférentiellement, la température prédéterminée Tref à partir de laquelle l'ailette 15 passe de la position rapprochée à la position éloignée, et inversement, est égale à la température de changement de phase du fluide de refroidissement 111. Du fait que la température T3 de l'ailette soit sensiblement égale à la température T2 du fluide de refroidissement 111, dès que le fluide de refroidissement 111 va chauffer de manière trop importante et va commencer à changer de phase, alors l'ailette 15 va se redresser pour passer de la position rapprochée à la position éloignée. Ce changement de position de l'ailette 15 permet de favoriser les échanges thermiques et d'éviter que la température T2 du fluide de refroidissement 111 n'augmente trop, que le changement de phase ne s'effectue et que la paroi 13 ne s'assèche. Cela permet ainsi de refroidir efficacement le circuit 20 en évitant notamment que la paroi 13 ne s'assèche. Le circuit 20 peut ainsi continuer de fonctionner à pleine puissance sans craindre d'échauffement pouvant endommager ce dernier.

Dans un mode de réalisation non illustré, il est envisageable que le dispositif 1 mette en œuvre une pluralité d'ailettes 15 dans le canal 11 de sorte à créer d'avantages de perturbations dans le flux 110 et donc d'améliorer encore les échanges thermiques entre le fluide de refroidissement 111 et le circuit 20.

Les ailettes 15 peuvent par exemple être disposées en ligne et en colonne, ou bien en quinconce, sur la paroi 13. Ces dispositions permettent de créer des perturbations qui optimisent les échanges thermiques. Avec ces dispositions, il est également possible d'anticiper, c'est-à-dire de prévoir, les perturbations qui seront créées par les ailettes 15 et donc quels seront les endroits où les échanges thermiques auront lieu. Il est donc également possible de disposer des ailettes 15 à des endroits spécifiques dans le canal 11 correspondant à des points du circuit 20 dégageant le plus de chaleur. Les ailettes 15 peuvent ainsi être placées dans les zones du canal 11 où des points chauds ont été identifiés. La densité des ailettes 15 peut être plus importante, par exemple deux fois supérieure, dans ces zones du canal 11 où des points chauds ont été identifiés que dans d'autres zones du canal 11 où aucun point chaud n'a été identifié. D'autres dispositions peuvent évidemment être envisagées sans s'écarter du principe de l'invention.

Les Figs. 2 et 3 représentent un système 10 de refroidissement selon l'invention comportant un dispositif 1 tel que décrit précédemment et un équipement électrique 2 à refroidir. Pour permettre le refroidissement de l'équipement électrique 2, la paroi 13 du dispositif 1 est alors mise en contact avec l'équipement électrique 2, et de préférence avec le circuit 20 qui génère le flux thermique 200, pour permettre les échanges thermiques entre le flux 110 de fluide de refroidissement 111 et le flux thermique engendré par le circuit 20.

La Fig. 5 représente un aéronef A comprenant au moins un système 10 de refroidissement tel que décrit ci-dessus. Dans cet exemple, plusieurs systèmes 10 sont mis en œuvre dans l'aéronef A. L'usage de tels systèmes 10 dans un aéronef permet avantageusement d'utiliser l'équipement électrique 2 en fonctionnement à pleine puissance sur des durées souhaitées, sans avoir la nécessité de diminuer la puissance pour cause d'échauffement intempestif de l'équipement électrique 2. De cette manière, l'utilisation de l'équipement électrique 2 est optimisée et correspond notamment aux contraintes de fonctionnement et d'encombrement rencontrées dans un aéronef.

## Revendications

1. Dispositif (1) de refroidissement d'un équipement électrique (2), ledit équipement électrique (2) comportant un circuit (20) dont la température (T1) est croissante entre un fonctionnement nominal dudit équipement électrique (2) dans lequel le circuit (20) délivre une puissance nominale (P1) et un fonctionnement critique dans lequel le circuit (20) délivre une puissance critique (P2) supérieure à la puissance nominale (P1),
ledit dispositif (1) comportant :
- un canal (11) de circulation contenant un flux (110) d'un fluide de refroidissement (111), ledit fluide de refroidissement (111) étant un fluide diphasique comportant une phase liquide (111a) et une phase gazeuse (111b),
- une paroi (13) thermiquement conductrice destinée à séparer ledit canal (11) et ledit circuit (20) et destinée à être en contact avec ledit circuit (20),
- au moins une ailette (15) disposée au sein dudit canal (11) et s'étendant à partir de ladite paroi (13), chaque ailette (15) comportant une extrémité proximale (151) solidaire de ladite paroi (13) et une extrémité distale (153) à l'opposé de l'extrémité proximale (151), chaque ailette (15) étant mobile entre une position rapprochée, dans laquelle l'extrémité distale (153) est rapprochée de ladite paroi (13), et une position éloignée, dans laquelle l'extrémité distale (153) est éloignée de ladite paroi (13) et fait au moins en partie obstacle audit flux (110) de fluide de refroidissement (111) ;
où ladite au moins une ailette (15) est configurée pour être en position rapprochée lorsqu'une température (T3) de l'ailette (15) est inférieure à une température prédéterminée (Tref), et être en position éloignée lorsque ladite température (T3) de l'ailette (15) est supérieure ou égale à ladite température prédéterminée (Tref) ;
et où ladite température prédéterminée (Tref) est égale à la température de changement de phase dudit fluide de refroidissement (111).

2. Dispositif (1) de refroidissement selon la revendication 1, **caractérisé en ce que** ladite au moins une ailette (15) comporte une première surface (150a) faisant face à ladite paroi (13) lorsque ladite au moins une ailette (15) est en position rapprochée, et une deuxième surface (150b) opposée à ladite première surface (150a),
où, dans la position éloignée, ladite au moins une ailette (15) est inclinée par rapport à ladite paroi (13) et où ledit flux (110) de fluide de refroidissement (111) circule en direction de ladite deuxième surface (150b) de ladite au moins une ailette (15).

3. Dispositif (1) de refroidissement selon l'une quelconque des revendications précédentes, **caractérisé en ce que** ladite au moins une ailette (15) comporte une première partie (155) en métal et une deuxième partie (157) en alliage à mémoire de forme.

4. Dispositif (1) de refroidissement selon la revendication 3, **caractérisé en ce que** ladite deuxième partie (157) comporte une première portion (157a) solidaire de ladite paroi (13) et une deuxième portion (157) solidaire de ladite première portion (157a) au niveau d'une jonction (157c) élastiquement déformable, ladite deuxième portion (157b) étant mobile par rapport à ladite paroi (13) entre la position rapprochée et la position éloignée.

5. Dispositif (1) de refroidissement selon la revendication 4, **caractérisé en ce que** ladite première partie (155) recouvre au moins en partie ladite deuxième portion (157b).

6. Dispositif (1) de refroidissement selon l'une quelconque des revendications 3 à 5, **caractérisé en ce que** ladite première partie (155) en métal est sélectionnée parmi : le cuivre, ou l'aluminium, ou l'or, ou l'inconel^{®}, et **en ce que** ladite deuxième partie (157) en alliage à mémoire de forme est sélectionnée parmi : le Nitinol, ou l'alliage Cuivre-Zinc-Aluminium, ou l'alliage Cuivre-Aluminium-Nickel, ou l'alliage Fer-Manganèse-Silicium.

7. Dispositif (1) de refroidissement selon l'une quelconque des revendications 4 à 6, **caractérisé en ce que** ladite deuxième portion (157b) présente une longueur (L₁) configurée pour que, lorsque ladite au moins une ailette (15) est en position éloignée, au moins l'extrémité distale (153) de ladite ailette (15) atteigne la phase liquide (111b) lorsque ladite paroi (13) est séparée de ladite phase liquide (11a) par la phase gazeuse (111b) dudit fluide de refroidissement (111).

8. Dispositif (1) de refroidissement selon l'une quelconque des revendications précédentes, **caractérisé en ce qu'**il comporte une pluralité d'ailettes (15), lesdites ailettes (15) étant disposées sur ladite paroi (13) en ligne, en quinconce, ou une combinaison de ces dispositions.

9. Système (10) de refroidissement comportant un équipement électrique (2) et un dispositif (1) de refroidissement selon l'une quelconque des revendications précédentes, où ladite paroi (20) dudit dispositif (1) est en contact avec ledit circuit (20) dudit équipement électrique (2).

10. Aéronef (A) comportant au moins un système (10) de refroidissement selon la revendication 9.

## Patentansprüche

1. Vorrichtung (1) zur Kühlung einer elektrischen Einrichtung (2), wobei die elektrische Einrichtung (2) einen Kreislauf (20) umfasst, dessen Temperatur (T1) zwischen einem Nennbetrieb der elektrischen Einrichtung (2), in dem der Kreislauf (20) eine Nennleistung (P1) abgibt, und einem kritischen Betrieb, in dem der Kreislauf (20) eine kritische Leistung (P2) abgibt, die höher als die Nennleistung (P1) ist, steigt,
wobei die Vorrichtung (1) umfasst:
- einen Zirkulationskanal (11), der einen Strom (110) eines Kühlfluids (111) enthält, wobei das Kühlfluid (111) ein Zweiphasenfluid ist, das eine flüssige Phase (111a) und eine gasförmige Phase (111b) umfasst,
- eine thermisch leitende Wand (13), die dazu bestimmt ist, den Kanal (11) und den Kreislauf (20) zu trennen, und dazu bestimmt ist, in Kontakt mit dem Kreislauf (20) zu sein,
- mindestens eine Lamelle (15), die innerhalb des Kanals (11) angeordnet ist und sich von der Wand (13) aus erstreckt, wobei jede Lamelle (15) ein mit der Wand (13) fest verbundenes proximales Ende (151) und ein zu dem proximalen Ende (151) entgegengesetztes distales Ende (153) umfasst, wobei jede Lamelle (15) beweglich ist zwischen einer angenäherten Position, in der das distale Ende (153) an die Wand (13) angenähert ist, und einer entfernten Position, in der das distale Ende (153) von der Wand (13) entfernt ist und den Strom (110) des Kühlfluids (111) mindestens zum Teil behindert;
wobei die mindestens eine Lamelle (15) dazu ausgestaltet ist, in der angenäherten Position zu sein, wenn eine Temperatur (T3) der Lamelle (15) geringer als eine vorbestimmte Temperatur (Tref) ist, und in der entfernten Position zu sein, wenn die Temperatur (T3) der Lamelle (15) größer oder gleich der vorbestimmten Temperatur (Tref) ist;
und wobei die vorbestimmte Temperatur (Tref) gleich der Phasenwechseltemperatur des Kühlfluids (111) ist.

2. Vorrichtung (1) zur Kühlung nach Anspruch 1, **dadurch gekennzeichnet, dass** die mindestens eine Lamelle (15) eine erste Fläche (150a), die der Wand (13) gegenüber liegt, wenn die mindestens eine Lamelle (15) in der angenäherten Position ist, und eine zweite Fläche (150b), die zu der ersten Fläche (150a) entgegengesetzt ist, umfasst,
wobei die mindestens eine Lamelle (15) in der entfernten Position in Bezug auf die Wand (13) geneigt ist und wobei der Strom (110) des Kühlfluids (111) in Richtung der zweiten Fläche (150b) der mindestens einen Lamelle (15) zirkuliert.

3. Vorrichtung (1) zur Kühlung nach einem der vorhergehenden Ansprüche, **dadurch gekennzeichnet, dass** die mindestens eine Lamelle (15) einen ersten Teil (155) aus Metall und einen zweiten Teil (157) aus Formgedächtnislegierung umfasst.

4. Vorrichtung (1) zur Kühlung nach Anspruch 3, **dadurch gekennzeichnet, dass** der zweite Teil (157) einen mit der Wand (13) fest verbundenen ersten Abschnitt (157a) und einen zweiten Abschnitt (157), der mit dem ersten Abschnitt (157a) an einem elastisch verformbaren Übergang (157c) fest verbunden ist, umfasst, wobei der zweite Abschnitt (157b) in Bezug auf die Wand (13) zwischen der angenäherten Position und der entfernten Position beweglich ist.

5. Vorrichtung (1) zur Kühlung nach Anspruch 4, **dadurch gekennzeichnet, dass** der erste Teil (155) den zweiten Abschnitt (157b) mindestens teilweise bedeckt.

6. Vorrichtung (1) zur Kühlung nach einem der Ansprüche 3 bis 5, **dadurch gekennzeichnet, dass** der erste Teil (155) aus Metall ausgewählt ist aus: Kupfer oder Aluminium oder Gold oder Inconel^{®} und dass der zweite Teil (157) aus Formgedächtnislegierung ausgewählt ist aus: Nitinol oder Kupfer-Zink-Aluminium-Legierung oder Kupfer-Aluminium-Nickel-Legierung oder Eisen-Mangan-Silicium-Legierung.

7. Vorrichtung (1) zur Kühlung nach einem der Ansprüche 4 bis 6, **dadurch gekennzeichnet, dass** der zweite Abschnitt (157b) eine Länge (L₁) aufweist, die so ausgestaltet ist, dass, wenn die mindestens eine Lamelle (15) in der entfernten Position ist, mindestens das distale Ende (153) der Lamelle (15) die flüssige Phase (111b) erreicht, wenn die Wand (13) von der flüssigen Phase (11a) durch die gasförmige Phase (111b) des Kühlfluids (111) getrennt ist.

8. Vorrichtung (1) zur Kühlung nach einem der vorhergehenden Ansprüche, **dadurch gekennzeichnet, dass** sie eine Mehrzahl von Lamellen (15) umfasst, wobei die Lamellen (15) auf der Wand (13) in einer Linie, versetzt oder in einer Kombination dieser Anordnungen angeordnet sind.

9. System (10) zur Kühlung, umfassend eine elektrische Einrichtung (2) und eine Vorrichtung (1) zur Kühlung nach einem der vorhergehenden Ansprüche, wobei die Wand (20) der Vorrichtung (1) mit dem Kreislauf (20) der elektrischen Einrichtung (2) in Kontakt ist.

10. Luftfahrzeug (A), das mindestens ein System (10) zur Kühlung nach Anspruch 9 umfasst.

## Claims

1. Device (1) for cooling an electrical equipment item (2), said electrical equipment item (2) comprising a circuit (20) whose temperature (T1) is increasing between a nominal operation of said electrical equipment item (2) in which the circuit (20) delivers a nominal power (P1) and a critical operation in which the circuit (20) delivers a critical power (P2) greater than the nominal power (P1),
said device (1) comprising:
- a circulation channel (11) containing a flow (110) of a coolant (111), said coolant (111) being a diphase fluid having a liquid phase (111a) and a gaseous phase (111b),
- a thermally conductive wall (13) intended to separate said channel (11) and said circuit (20) and intended to be in contact with said circuit (20),
- at least one fin (15) disposed within said channel (11) and extending from said wall (13), each fin (15) comprising a proximal end (151) secured to said wall (13) and a distal end (153) opposite the proximal end (151), each fin (15) being movable between a close position, in which the distal end (153) is close to said wall (13), and a distant position, in which the distal end (153) is distant from said wall (13) and at least partly forms an obstacle to said flow (110) of coolant (111);
in which said at least one fin (15) is configured to be in close position when a temperature (T3) of the fin (15) is less than a predetermined temperature (Tref), and to be in distant position when said temperature (T3) of the fin (15) is greater than or equal to said predetermined temperature (Tref);
and in which said predetermined temperature (Tref) is equal to the phase-change temperature of said coolant (111).

2. Cooling device (1) according to Claim 1, **characterized in that** said at least one fin (15) comprises a first surface (150a) facing said wall (13) when said at least one fin (15) is in close position, and a second surface (150b) opposite said first surface (150a),
in which, in the distant position, said at least one fin (15) is inclined with respect to said wall (13) and in which said flow (110) of coolant (111) circulates towards said second surface (150b) of said at least one fin (15).

3. Cooling device (1) according to any one of the preceding claims, **characterized in that** said at least one fin (15) comprises a first part (155) made of metal and a second part (157) made of alloy with shape memory.

4. Cooling device (1) according to Claim 3, **characterized in that** said second part (157) comprises a first portion (157a) secured to said wall (13) and a second portion (157) secured to said first portion (157a) at an elastically deformable join (157c), said second portion (157b) being movable with respect to said wall (13) between the close position and the distant position.

5. Cooling device (1) according to Claim 4, **characterized in that** said first part (155) at least partly covers said second portion (157b).

6. Cooling device (1) according to any one of Claims 3 to 5, **characterized in that** said first part (155) made of metal is selected from among: copper, or aluminium, or gold, or inconel^{®}, and **in that** said second part (157) made of alloy with shape memory is selected from among: Nitinol, or the Copper-Zinc-Aluminium alloy, or the Copper-Aluminium-Nickel alloy, or the Iron-Manganese-Silicon alloy.

7. Cooling device (1) according to any one of Claims 4 to 6, **characterized in that** said second portion (157b) has a length (L₁) configured so that, when said at least one fin (15) is in distant position, at least the distal end (153) of said fin (15) reaches the liquid phase (111b) when said wall (13) is separated from said liquid phase (11a) by the gaseous phase (111b) of said coolant (111).

8. Cooling device (1) according to any one of the preceding claims, **characterized in that** it comprises a plurality of fins (15), said fins (15) being disposed on said wall (13) in a line, staggered, or a combination of these dispositions.

9. Cooling system (10) comprising an electrical equipment item (2) and a cooling device (1) according to any one of the preceding claims, in which said wall (20) of said device (1) is in contact with said circuit (20) of said electrical equipment item (2).

10. Aircraft (A) comprising at least one cooling system (10) according to Claim 9.
